# EUROPEAN PATENT APPLICATION

(11) **EP 0 914 030 A1**
(43) Date of publication of application: **06.05.1999**
(21) Application number: 97308604.4
(22) Date of filing: 28.10.1997
(51) Int. Cl.: H05K 7/20

(54) **Enclosure for equipment which requires cooling**

(71) Applicant: LUCENT TECHNOLOGIES INC., Murray Hill, New Jersey 07974-0636 (US)
(72) Inventor: Gates, William George, Wolverton, Milton Keynes MK12 5DX (GB); Bestwick, Graham Spencer, Berks RG17 8YZ (GB); Falaki, Hamid Rezo, Grange Park, Swindon SN5 6HD (GB); Kelly, Daniel Peter, Donnybrook, Dulblin 4 (IE)
(74) Representative: Johnston, Kenneth Graham

(57) **Abstract**

Externally mounted enclosures for mobile radio base stations potentially experience a wide range of ambient temperatures. In temperate climates, it is possible for the heat generated by the internal electronics to be dissipated by natural convention. In hotter climates this becomes difficult or impossible, however.

An enclosure is disclosed having an inner case 2 for containing the equipment. The case 2 is formed with heat conductive fins 4 extending vertically, in use, so as to define channels 8 therebetween. An outer case 10 contains the inner case and defines air passages 12 into which the fins project. The outer case has vents 14 and 16 to allow convection through the channels between the fins. A fan unit 24 is located at or towards the upper end of the air passages and laterally of the air passages to draw air therefrom. Control means is provided for controlling operation of the fan unit according to temperature.

The fan unit is located so that it does not obstruct the air passages and thus does not impede natural convection. When the fan unit is switched on, it increases the flow of air in the channels between the fins so increasing cooling.

## Description

This invention relates to an enclosure for equipment which requires cooling.

The background to the invention will be explained in relation to one particular application. The reader will readily understand that the invention may be used in other applications.

Externally mounted enclosures for mobile radio base stations potentially experience a wide range of ambient temperatures. In temperate climates, it is possible for the heat generated by the internal electronics to be dissipated by natural convention. In hotter climates this becomes difficult or impossible, however.

Against this background, in accordance with the invention, there is provided an enclosure for equipment which requires cooling, comprising: an inner case for containing the equipment, said case being formed with heat conductive fins extending vertically, in use, so as to define channels therebetween; an outer case containing said inner case and defining air passages into which the fins project, the outer case having vents to allow convection through the channels between the fins; a fan unit located at or towards the upper end of the air passages laterally of the air passages to draw air therefrom; and control means for controlling operation of the fan unit according to temperature.

The fan unit is located so that it does not obstruct the air passages and thus does not impede natural convection. When the fan unit is switched on, it increases the flow of air in the channels between the fins so increasing cooling.

Preferably, the vents are above the top of the fins and below the bottom of the fins. There may be additional vents in the sides of the air passages.

Conveniently, the fan unit may be located over the inner case.

In a preferred form, the fan unit contains one or more centrifugal fans positioned with their inlets facing downwardly, in use. This has the advantage that if solids become entrained in the airflow, any which do not pass through the fan drop out when the fan is switched off.

One embodiment of the invention will now be described, by way of example, with reference to the accompanying drawings; in which:

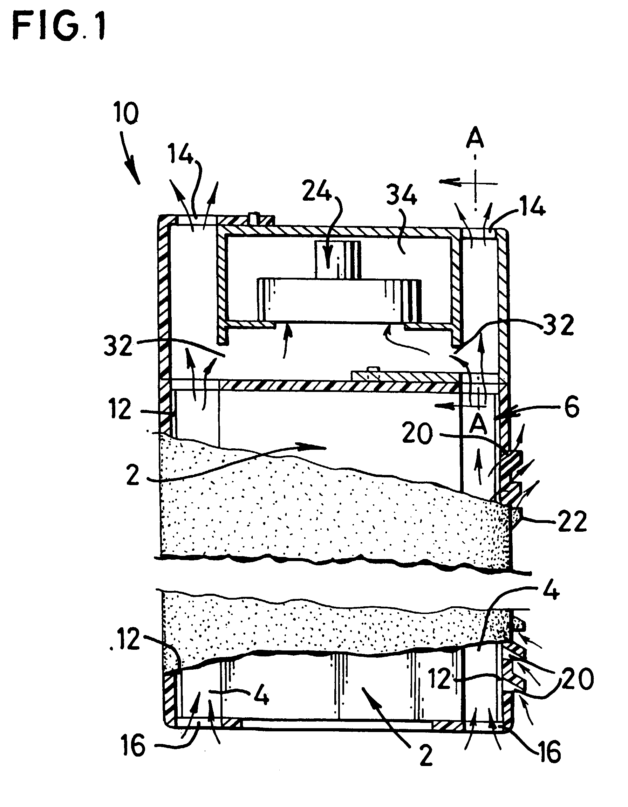

Figure 1 is a cross section through an enclosure embodying the invention;

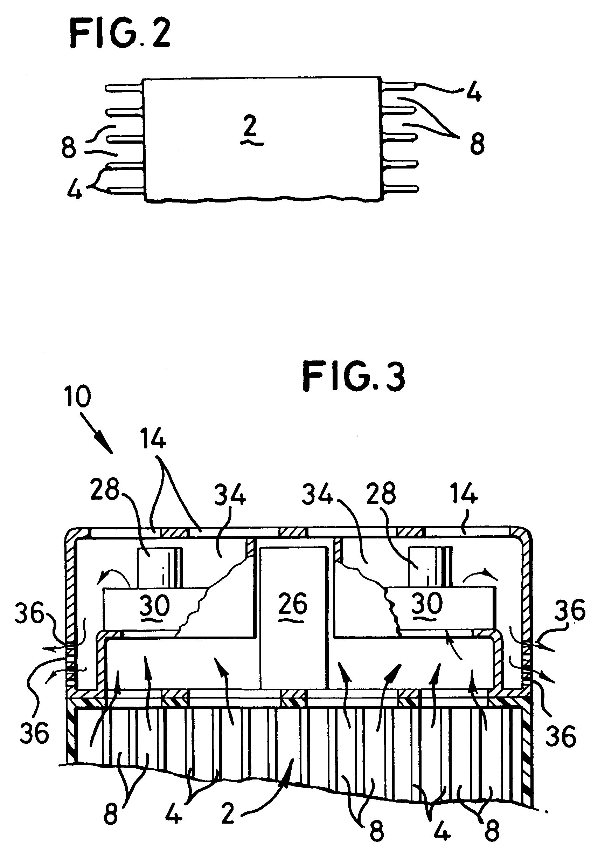

Figure 2 is a plan view of the inside case of the enclosure of t Figure 1; and
Figure 3 is a cross section on line AA of the fan unit in the direction of the arrows.

Referring to the drawings, an inner case 2 is cast from light metal with vertical fins 4 on two opposite faces 6. The fins define channels 8 therebetween.

An outer case 10 encloses the inner case 2 defining therewith air passages 12 into which the fins project. The outer ends of the fins 4 may be proximate the walls of the outer enclosure, as shown, or may be further spaced therefrom.

The outer case 10 is formed with vents 14 above the air passages 12 and vents 16 below the air passages 12. Further vents 20 may be provided in the side walls 22 of the outer case.

A fan unit 24 is located at or towards the upper end of the air passages laterally of the air passages to draw air therefrom. In the embodiment illustrated, the fan unit 24 is located inside the outer casing above the inner casing and is dimensioned so as not to obstruct the air passages 12 significantly. Natural convection is thus not significantly impeded by the provision of the fan unit.

Control unit 26 receives a signal from a temperature sensor inside the inner enclosure. When a predetermined temperature is reached at which natural convection is not sufficient, the motors 28 driving two downwardly facing centrifugal fans 30 are switched on. The fans draw air in laterally through passages 32 from the air passages 12 so increasing the flow of air in the channels 8 between the fins 4 and thus increasing cooling. Air is drawn into a chamber 34 and exits through openings 36.

## Claims

1. An enclosure for equipment which requires cooling, comprising: an inner case for containing the equipment, said case being formed with heat conductive fins extending vertically, in use, so as to define channels therebetween; an outer case containing said inner case and defining air passages into which the fins project, the outer case having vents to allow convection through the channels between the fins; a fan unit located at or towards the upper end of the air passages laterally of the air passages to draw air therefrom; and control means for controlling operation of the fan unit according to temperature.

2. An enclosure as claimed in claim 1, wherein the vents are above the top of the fins and below the bottom of the fins.

3. An enclosure as claimed in claim 1 or 2. wherein the fan unit is located over the inner case.

4. An enclosure as claimed in any preceding claim, wherein the fan unit contains one or more centrifugal fans positioned with their inlets facing downwardly, in use.
